# EUROPÄISCHE PATENTANMELDUNG

(11) **EP 0 950 901 A2**
(43) Veröffentlichungstag der Anmeldung: **20.10.1999**
(21) Anmeldenummer: 99104002.3
(22) Anmeldetag: 12.03.1999
(51) Int. Cl.: G01R 31/28, G01R 31/327

(54) **Prüfeinrichtung für ein elektronisches Gerät, insbesondere ein Überstromrelais**

(30) Priorität: 14.04.1998 DE 29806674 U
(71) Anmelder: ABB PATENT GmbH, 68309 Mannheim (DE)
(72) Erfinder: Asaah, Eniet T, Dipl.Ing.,, 64289 Darmstadt (DE); Cwetanski, Georgi, Dipl.-Ing.,, 67227 Frankenthal (DE); Rempt, Bernd, Dipl.-Ing,, 68219 Mannheim (DE)
(74) Vertreter: Miller, Toivo

(57) **Zusammenfassung**

Es wird eine Prüfeinrichtung für ein elektronisches Gerät, insbesondere ein elektronisches Überlastrelais beschrieben, bei dem elektrische und elektronische Komponenten (11, 12) auf wenigstens einer in einem Gehäuse untergebrachten Leiterplatte (10) aufgebracht sind. Die Komponenten (11, 12) sind über auf der Leiterplatte (10) befindliche Leiterbahnen (13, 14, 15, 16, 17) mit je einem Kontaktierpunkt (18, 19) elektrisch leitend verbunden. In der Gehäusewandung oberhalb der Leiterplatte (10) sind den Kontaktierpunkten (18, 19) entsprechende Löcher (21, 22) vorgesehen, die direkt oberhalb jeweils eines Kontaktierpunktes (18, 19) liegen und mit diesen fluchten. Weiterhin ist ein Prüfgerät (28) vorgesehen ist, das Prüfstifte (23 bis 27) enthält, die zur Prüfung der Komponenten (11, 12) in alle oder einen Teil der Löcher (21, 22) eingeführt und auf die Kontaktierpunkte (18, 19) aufgedrückt werden können.

## Beschreibung

Die Erfindung betrifft eine Prüfeinrichtung für insbesondere ein elektronisches Gerät, insbesondere ein Überlastrelais, nach dem Oberbegriff des Anspruches 1.

Elektronische Überlastrelais z. B. sind bei der Montage einer Funktionsprüfung zu unterziehen, bei der insbesondere einzelne Komponenten auf ihre korrekte Funktion überprüft werden sollen. Dies erfolgt z. B. bei einem elektronischen Überlastrelais derzeit dann, wenn die Komponenten tragende Leiterplatte bestückt ist, noch vor dem Einbau in ein Gehäuse.

Aufgabe der Erfindung ist es, eine Prüfeinrichtung der eingangs genannten Art zu schaffen, mit der die Komponenten insbesondere eines elektronischen Überlastrelais nach kompletter Montage überprüft werden können.

Diese Aufgabe wird erfindungsgemäß durch die kennzeichnenden Merkmale des Anspruches 1 gelöst.

Erfindungsgemäß also sind die Komponenten des elektronischen Gerätes, insbesondere des Überlastrelais, über auf der Leiterplatte befindliche Leiterbahnen mit je einem Kontaktierpunkt elektrisch leitend verbunden; in der Gehäusewandung direkt und unmittelbar oberhalb der Kontaktierpunkte befinden sich Löcher, die mit je einem Kontaktierpunkt fluchten, und zur Prüfung wird in die Löcher eine Prüfeinrichtung mit ihren Stiften eingesteckt, die die Kontaktierpunkte kontaktieren, wodurch eine Prüfung durchgeführt werden kann nach der kompletten Montage des elektronischen Gerätes.

Mit der erfindungsgemäßen Ausführungsform und Ausgestaltung kann somit eine notwenidge Prüfung aller elektronischen Komponenten eines elektronischen Gerätes auch nach Beendigung des kompletten Montagevorganges vorgenommen werden.

Die Prüflöcher besitzen einen Durchmesser, der dem Außendurchmesser der Prüfstifte angepaßt ist und der eine solche Größe hat, daß er den einschlägigen Vorschriften genügt. Gegebenenfalls können die Prüflöcher mittels einer Prüfabdeckung abgeklebt werden.

Anhand der Zeichnung, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigen:

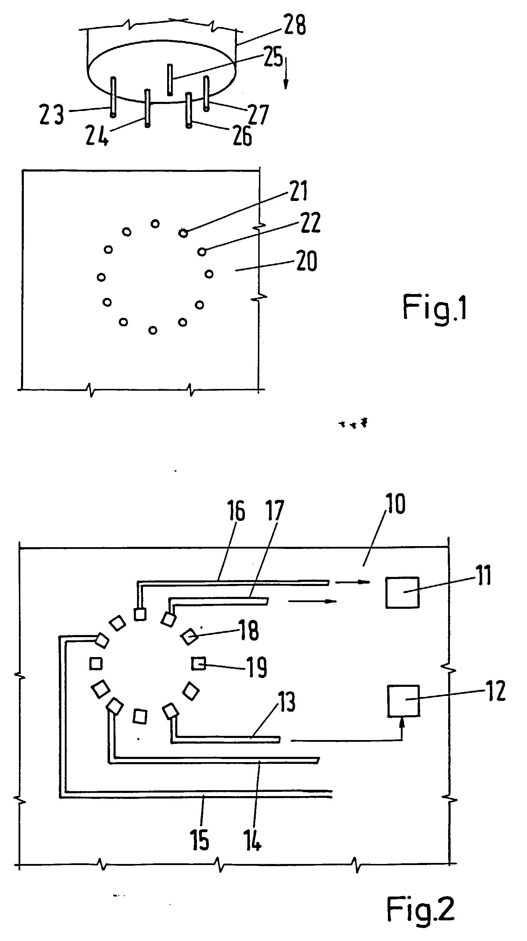

- Fig. 1: eine Prüfeinrichtung und ein Gehäuse mit Prüflöchern, und
- Fig. 2: eine Leiterplatte mit Kontaktierungspunkten.

Auf einer Leiterplatte 10 befinden sich elektrische bzw. elektronische Komponenten 11, 12 und weitere nicht näher dargestellte Komponenten, die mittels Leiterbahnen 13, 14, 15, 16 und 17 mit Kontaktierpunkten 18, 19 elektrisch leitend verbunden sind, welche Kontaktierpunkte 18, 19 auf einem Kreis angeordnet und voneinander elektrisch isoliert sind. Bei der Ausführung gemäß der einzigen Figur befinden sich auf der Leiterplatte zwölf Kontaktierpunkte, von denen lediglich fünf Kontaktierpunkte mit den Leiterbahnen 13 bis 17 elektrisch leitend verbunden sind.

Die Leiterplatte 10 befindet sich in einem Gehäuse (nicht dargestellt), welches von einer Gehäuseabdeckung 20 abgedeckt ist, die eine der Anzahl der Kontaktierpunkte 18 und 19 entsprechende Anzahl von Löchern 21, 22 aufweist, die nach Einbau der Leiterplatte 10 mit den Komponenten 11, 12 in das Gehäuse exakt oberhalb der Kontaktierstifte 18, 19 liegen. Durch diese Löcher 21, 22 können Prüfstifte 23, 24, 25, 26 und 27 eines Prüfgerätes 28 hindurchgesteckt werden. Bei der dargestellten Ausführungsform besitzt das Prüfgerät fünf Prüfstifte entsprechend der Anzahl der fünf mit den Leiterbahnen 13 bis 17 verbundenen Kontaktierpunkte.

Nachdem die Leiterplatte 10 mit den darauf aufgebrachten Komponenten 11 und 12 in das Gehäuse eingesetzt und der Deckel 20 auf das Gehäuse aufgesetzt ist, können die einzelnen Komponenten 11 und 12 mittels des Prüfgerätes 28 dadurch geprüft werden, daß die Prüfstifte durch die Löcher 21, 22 hindurchgesteckt werden, so daß sie mit den Kontaktierpunkten 18 und 19 in Verbindung gelangen bzw. diese berühren und auf diese Weise eine Prüfung der Komponenten durchgeführt werden kann.

Der Durchmesser der Löcher entspricht dem Außendurchmesser der Kontaktierstifte und kann bei einer bestimmten Ausführungsform einen Wert von ca. 1,5 mm betragen.

Es besteht die Möglichkeit, eine Abdeckung aufzukleben, mit der für bestimmte Zwecke die Löcher 21, 22, die ebenfalls im Kreis eingeordnet sind wie die Kontaktierpunkte 18 und 19, abgedeckt werden können.

Es besteht natürlich auch die Möglichkeit, daß die Kontaktierpunkte und die Löcher in einer Linie oder nebeneinander auf parallelen Linien oder in einem Drei- oder Vier- oder Mehreck angeordnet sein können.

## Patentansprüche

1. Prüfeinrichtung für ein elektronisches Gerät, insbesondere ein elektronisches Überlastrelais, mit auf wenigstens einer in einem Gehäuse untergebrachten Leiterplatte (10) aufgebrachten elektrischen und elektronischen Komponenten (11, 12) des elektronischen Gerätes, dadurch gekennzeichnet, daß die Komponenten (11, 12) über auf der Leiterplatte (10) befindliche Leiterbahnen (13, 14, 15, 16, 17) mit je einem Kontaktierpunkt (18, 19) elektrisch leitend verbunden sind, das in der Gehäusewandung oberhalb der Leiterplatte (10) den Kontaktierpunkten (18, 19) entsprechende Löcher (21, 22) vorgesehen sind, die direkt oberhalb jeweils eines Kontaktierpunktes (18, 19) liegen und mit diesen fluchten, und daß ein Prüfgerät (28) vorgesehen ist, das Prüfstifte (23 bis 27) enthält, die zur Prüfung der Komponenten (11, 12) in alle oder einen Teil der Löcher (21, 22) einführbar und auf die Kontaktierpunkte (18, 19) aufdrückbar sind.

2. Prüfeinrichtung nach Anspruch 1, dadurch gekennzeichnet, daß der Außendurchmesser der Löcher höchstens 1,5 mm beträgt.

3. Prüfeinrichtung nach Anspruch 1 oder 2, dadurch gekennzeichnet, daß die Löcher (21, 22) mittels einer Abdeckfolie oder dergleichen abgedeckt sind.
